# EUROPEAN PATENT APPLICATION

(11) **EP 4 763 599 A1**
(43) Date of publication of application: **24.06.2026**
(21) Application number: 24907759.5
(22) Date of filing: 31.10.2024
(51) Int. Cl.: B60L 58/16, B60L 58/12, G01R 31/367, G01R 31/392, G01R 31/382, G01R 31/396, H01M 10/42

(54) **BATTERY MANAGEMENT DEVICE, BATTERY MANAGEMENT METHOD, AND VEHICLE**

(30) Priority: 20.12.2023 KR 20230187453; 08.03.2024 KR 20240033417; 30.10.2024 KR 20240151330
(71) Applicant: LG Energy Solution, Ltd., Seoul 07335 (KR)
(72) Inventor: KIM, Jae Gu, Daejeon 34122 (KR)
(74) Representative: Plasseraud IP
(86) International application number: PCT/KR2024/016923
(87) International publication number: WO 2025/135474

(57) **Abstract**

A battery management apparatus includes a memory and a processor operatively connected to the memory. The processor determines an operating range of the battery pack based on battery state variables; calculates degradation rate values of the battery state variables based on energy degradation parameters; measures a usable battery energy (UBE) to be supplied by the battery pack based on a standard test pattern; and estimates a state of certified energy (SOCE) of the battery pack by comparing a measured UBE value with a reference UBE value.

## Description

### Technical Field

### CROSS REFERENCE TO RELATED APPLICATION

This application is based on and claims priority from Korean Patent Application Nos. 10-2023-0187453, 10-2024-0033417 and 10-2024-0151330, filed on December 20, 2023, March 8, 2024 and October 30, 2024, respectively, with the Korean Intellectual Property Office, the disclosures of which are incorporated herein in their entireties by reference.

### Technical Field

The embodiments disclosed herein relate to a battery management apparatus, a battery management method, and a vehicle.

### Background Art

Recently, research and development on secondary batteries have been actively conducted. Here, secondary batteries, which are rechargeable batteries, may be interpreted as encompassing both conventional batteries such as Ni/Cd batteries and Ni/MH batteries, as well as recent lithium-ion batteries. Among the secondary batteries, lithium-ion batteries may have a higher energy density than, for example, conventional Ni/Cd batteries and Ni/MH batteries, and may be manufactured to be small and lightweight, providing high versatility as power sources for mobile devices. For example, lithium-ion batteries have recently been attracting attention as a next-generation energy storage medium due to their expanded use as a power source for electric vehicles.

### Disclosure

### Technical Problem

Embodiments disclosed herein provide a battery management apparatus, a battery management method, and a vehicle capable of estimating the state of certified energy (SOCE) value of a vehicle battery.

### Technical Solution

According to the embodiments of the present disclosure, a battery management apparatus includes a memory and a processor operatively connected to the memory. The processor is configured to: determine an operating range of the battery pack based on battery state variables; calculate degradation rate values of the battery state variables based on energy degradation parameters; measure a usable battery energy (UBE) to be supplied by the battery pack based on a standard test pattern; and estimate a SOCE of the battery pack by comparing a measured UBE value with a reference UBE value.

According to the embodiments, the battery management apparatus includes a sensor configured to collect battery data from the battery pack, and the processor is configured to generate the battery state variables based on the battery data.

According to the embodiments, the battery state variables include the state of charge (SOC), the state of health capacity (SOHC), and the state of health resistance (SOHR) of the battery pack, and the operating range includes a SOC operating range defined by an upper SOC limit and a lower SOC limit.

According to the embodiments, the energy degradation parameters include a first degradation parameter related to a rate at which a decrease in the SOHC contributes to energy degradation, and a second degradation parameter related to a rate at which an increase in the SOHR contributes to energy degradation.

According to the embodiments, the degradation rate values of the battery state variables include a first degradation rate value related to the degradation of the SOHC and a second degradation rate value related to the degradation of the SOHR.

According to the embodiments, the battery pack includes multiple battery cells. The processor is configured to: determine multiple SOC operating ranges based on multiple SOCs corresponding to the multiple battery cells; and measure the UBE based on multiple SOHCs, multiple SOHRs, and the multiple SOC operating ranges corresponding to the multiple battery cells.

According to the embodiments, the processor is configured to: calculate a maximum SOC value, a minimum SOC value, and an average SOC value based on the multiple SOCs; select a representative SOHC value and a representative SOHR value from the multiple SOHCs and SOHRs; and measure the UBE based on the maximum SOC value, the minimum SOC value, the average SOC value, the representative SOHC value, and the representative SOHR value.

According to the embodiments, the processor is configured to: calculate a cell UBE value for each of the multiple battery cells based on the multiple SOHCs, the multiple SOHRs, and the multiple SOC operating ranges; and calculate a pack UBE value of the battery pack based on an energy loss caused by an internal resistance of the battery pack and the cell UBE values of the multiple battery cells.

According to the embodiments, the processor is configured to: calculate a vehicle UBE value based on an energy efficiency of a power system of a vehicle that uses the battery pack as a power source and the pack UBE value; and estimate the SOCE by comparing the vehicle UBE value with the reference UBE value.

According to embodiments, the processor is configured to calculate the cell UBE value for each of the multiple battery cells using at least one of an energy map and an equivalent circuit model.

According to the embodiments, a battery management method includes: determining an operating range of a battery pack based on battery state variables; calculating degradation rate values of the battery state variables based on an energy degradation parameter; measuring a UBE to be supplied by the battery pack based on a standard test pattern; and estimating a SOCE of the battery pack by comparing a measured UBE value with a reference UBE value.

According to the embodiments, the battery state variables include a SOC, a SOHC, and a SOHR of the battery pack, and the operating range includes a SOC operating range defined by an upper SOC limit and a lower SOC limit.

According to embodiments, the battery pack includes multiple battery cells, and the measuring the UBE includes: determining multiple SOC operating ranges based on multiple SOCs corresponding to the multiple battery cells; and measuring the UBE based on multiple SOHCs, multiple SOHRs, and the multiple SOC operating ranges corresponding to the multiple battery cells.

According to the embodiments, the measuring the UBE includes: calculating a cell UBE value for each of the multiple battery cells based on the multiple SOHCs, the multiple SOHRs, and the multiple SOC operating ranges; and calculating a pack UBE value of the battery pack based on an energy loss caused by an internal resistance of the battery pack and the cell UBE values of the multiple battery cells.

According to the embodiments, the estimating the SOCE includes: calculating a UBE value based on an energy efficiency of a power system of a vehicle using the battery pack as a power source and the pack UBE value; and estimating the SOCE by comparing the vehicle UBE value with the reference UBE value.

According to the embodiments, a vehicle includes a battery pack, and a battery management apparatus. The battery management apparatus is configured to: determine an operating range of the battery pack based on battery state variables; calculate degradation rate values of the battery state variables based on an energy degradation parameter; measuring a UBE to be supplied by the battery pack based on a standard test pattern; and estimate a SOCE of the battery pack by comparing a measured UBE value with a reference UBE value.

According to the embodiments, the battery state variables include a SOC, a SOHC, and a SOHR of the battery pack, and the operating range includes an SOC operating range defined by an upper SOC limit and a lower SOC limit.

According to the embodiments, the battery pack includes multiple battery cells, and the battery management apparatus is configured to: determine multiple SOC operating ranges based on multiple SOCs corresponding to the multiple battery cells; and measure the UBE based on multiple SOHCs, multiple SOHRs, and the multiple SOC operating ranges corresponding to the multiple battery cells.

According to the embodiments, the battery management apparatus is configured to: calculate a cell UBE value for each of the multiple battery cells based on the multiple SOHCs, the multiple SOHRs, and the multiple SOC operating ranges; and calculate a pack UBE value of the battery pack based on an energy loss caused by an internal resistance of the battery pack and the cell UBE values of the multiple battery cells.

According to the embodiments, the battery management apparatus is configured to: calculate a vehicle UBE value based on an energy efficiency of a power system of a vehicle that uses the battery pack as a power source and the pack UBE value; and estimate the SOCE by comparing the vehicle UBE value with the reference UBE value.

### Advantageous Effects

According to the embodiments disclosed herein, a battery management apparatus, a battery management method, and a vehicle capable of estimating the SOCE value of a vehicle battery may be provided.

The technical effects according to the embodiments disclosed herein are not limited to the above-mentioned effects, and other effects not mentioned above will be clearly understood by a person ordinarily skilled in the art according to the disclosure of this document.

### Description of Drawings

The following drawings attached hereto illustrate embodiments of the present disclosure and serve to help further understand the technical idea of the present disclosure together with the detailed description of the disclosure to be described later. Therefore, the present disclosure should not be construed as being limited to the matters illustrated in the drawings.
FIG. 1 illustrates the components constituting a vehicle according to an embodiment of the present disclosure.
FIG. 2 illustrates the components constituting a battery management apparatus according to an embodiment of the present disclosure.
FIG. 3 illustrates a first logic and a second logic for estimating energy durability according to an embodiment of the present disclosure.
FIG. 4 illustrates a process in which the second logic operates according to an embodiment of the present disclosure.
FIGS. 5 to 7 illustrate each step of the second logic for estimating a SOCE according to an embodiment of the present disclosure.
FIG. 8 illustrates a process of estimating a SOCE using representative values according to an embodiment of the present disclosure.
FIG. 9 illustrates a Worldwide Harmonized Light Vehicles Test Procedure (WLTP) performed to estimate the SOCE according to an embodiment of the present disclosure.
FIG. 10 illustrates test cases for estimating the SOCE according to an embodiment of the present disclosure.
FIG. 11 illustrates steps constituting a battery management method according to an embodiment of the present disclosure.

### Mode for Invention

Hereinafter, embodiments described herein will be described with reference to the attached drawings. However, this is not intended to limit the present disclosure to specific embodiments, and should be understood to include various modifications, equivalents, and/or alternatives to the embodiments described herein.

The embodiments described herein and the terms used are not intended to limit the technical features described herein to specific embodiments and should be understood to include various modifications, equivalents, or substitutes of the embodiments. In relation to the description of the drawings, similar reference numerals may be used for similar or related components. The singular form of a noun corresponding to an item may include one or more instances of the item unless the relevant context clearly indicates otherwise.

Herein, each of phrases, such as "A or B," "at least one of A and B," "at least one of A or B," "A, B, or C," "at least one of A, B, and C, and "at least one of A, B, or C," may include any one of the items listed together in the corresponding phrase or all possible combinations of these items. Terms such as "first," "second," "primary," "secondary," "A," "B," "(a)," or "(b)" may be used to distinguish the corresponding component from other corresponding components, and, unless specifically stated otherwise, do not limit the components in other respects (e.g., importance or order).

Herein, when a certain (e.g., first) component is described as being "connected," "coupled," or "linked" to another (e.g., second) component, either functionally or communicatively, with or without these terms, it means that the certain component may be connected directly (e.g., either by wire or wirelessly) or indirectly (e.g., via a third component) to the other component.

Methods according to various embodiments disclosed herein may be included in and provided as a computer program product. The computer program product may be traded as a product between a seller and a purchaser. The computer program product may be distributed in the form of a machine-readable storage medium (e.g., compact disc read only memory (CD-ROM)), or may be distributed (e.g., downloaded or uploaded) online through an application store or directly between two driver devices. In the case of online distribution, at least part of the computer program product may be temporarily stored or produced in a machine-readable storage medium such as a manufacturer's server, a server of an application store, or the memory of a relay server.

According to the embodiments disclosed herein, each of the above-described components (e.g., module or program) may include either a single entity or multiple entities, and some of the multiple entities may be placed separately from other components. According to the embodiments disclosed herein, one or more of the above-described components or operations may be omitted, or one or more other components or operations may be added. Alternatively or additionally, multiple components (e.g., modules or programs) may be integrated into a single component. In such a case, the integrated component may perform one or more functions of each of the multiple components in the same or a similar manner as performed by the corresponding one of the multiple components before the integration. According to the embodiments disclosed herein, operations performed by a module, a program, or other components may be executed sequentially, in parallel, repetitively, or heuristically, one or more of the operations may be executed in a different order or omitted, or one or more other operations may be added.

As the application range of secondary batteries, including lithium-ion batteries, expands to areas such as automobiles, research on managing and predicting the energy of batteries, such as estimating the energy durability of secondary batteries, is actively being conducted.

Previously, the energy durability of secondary batteries was estimated using the constant current (CC) energy at the pack level. However, with the establishment of the Global Technical Regulation No. 22 (GTR22) international standard, the battery management system (BMS) of xEV batteries, including electric vehicles (EVs), hybrid electric vehicles (HEVs), and plug-in hybrid electric vehicles (PHEVs), is now required to mandatorily estimate an energy durability value called the state of certified energy (SOCE). The SOCE, defined by the international standard, refers to the degree of durability degradation of the energy that a battery can supply when a vehicle is driven based on the Worldwide Harmonized Light Vehicles Test Procedure (WLTP), and the BMS is required to predict a decrease in the SOCE value. According to the international standard, the estimation logic of the SOCE should satisfy the error condition of less than 5%, and when this condition is not met, it may be subject to, for example, a software (SW) recall.

Meanwhile, conventional technologies are limited to predicting battery durability based solely on the state of health capacity (SOHC) and state of health resistance (SOHR), which may make it difficult to meet the revised international standards. The present disclosure provides a new energy durability estimation method that satisfies international standards by taking these circumstances into consideration.

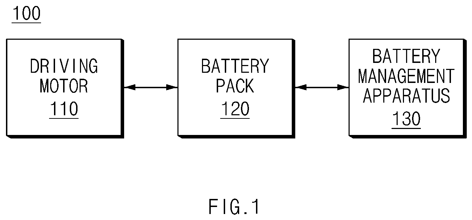

FIG. 1 illustrates the components constituting a vehicle according to an embodiment of the present disclosure.

Referring to FIG. 1, the vehicle 100 may include a driving motor 110, a battery pack 120, and a battery management apparatus 130. However, the present disclosure is not limited thereto, and some components may be omitted from the vehicle 100, or other general components may be further included in the vehicle 100.

The vehicle 100 may operate the driving motor 110 using a battery pack 120 as a power source. According to an embodiment, the vehicle 100 may be, for example, an EV, a HEV, or an electric bicycle. The vehicle 100 may drive the driving motor 110 based on the power of the battery pack 120, or charge the battery pack 120 using the electric power generated through regenerative braking, which converts the kinetic energy generated during vehicle braking into electrical energy to charge the battery.

The battery pack 120 may supply power to the electronic devices of the vehicle 100, including the driving motor 110. The battery pack 120 may include multiple battery modules, and each battery module may include multiple battery cells. The battery pack 120 may include, for example, lithium iron phosphate (LFP) batteries, nickel cobalt manganese (NCM) batteries, and sodium vanadium fluorophosphate (NVPF) batteries.

The battery management apparatus 130 may perform operations for the diagnosis or management of the battery pack 120. The battery management apparatus 130 may measure battery data from the battery pack 120 and, based on this data, diagnose or manage the state of the battery pack 120.

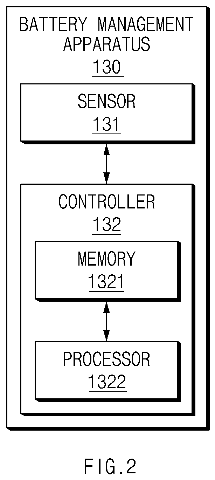

FIG. 2 illustrates the components constituting the battery management apparatus 130 according to an embodiment of the present disclosure.

Referring to FIG. 2, the battery management apparatus 130 may include a sensor 131 and a controller 132. However, the present disclosure is not limited thereto, and some components may be omitted from the battery management apparatus 130, or other general components may be further included in the battery management apparatus 130.

According to an embodiment, the sensor 131 and the controller 132 in the battery management apparatus 130 may be electrically connected to each other through an inter-device communication scheme. The inter-device communication scheme may include, for example, a bus, a general purpose input and output (GPIO), a serial peripheral interface (SPI), and a mobile industry processor interface (MIPI).

The sensor 131 may be configured to generate various battery measurements from the battery 120 to be diagnosed. For this purpose, the sensor 131 may include measuring means such as a voltage sensor, a current sensor, and a temperature sensor. According to an embodiment, the sensor 131 in the battery management apparatus 130 may be replaced by an interface configured to acquire battery data of the battery 120. The interface may include a communication unit configured to receive battery data measured by an external sensor and/or a sensor unit configured to directly measure the battery data. According to an embodiment, when the battery management apparatus 130 is configured in an on-board manner, it may be implemented in the form of a battery management system (BMS) mounted together with the battery 120, and the interface of the battery management apparatus 130 may include a sensor unit configured to directly measure the battery data. When the battery management apparatus 130 is configured in an off-board manner, it may be implemented in the form of an external device operating remotely from the battery 120, and the external device may include a charger of a battery charging station, a battery diagnostic device, a cloud computing server, or the like. In the case of the off-board configuration, the interface of the battery management apparatus 130 may include a communication unit configured to receive battery data measured by an external sensor. The communication unit may receive battery data through wired data communication, wireless data communication, or the like.

The controller 132 may include memory 1321 and a processor 1322. The memory 1321 may store, for example, data, instructions, software, mobile applications, or computer programs. The processor 1322 may execute instructions stored in the memory 1321 to perform various calculation. The memory 1321 may include at least one of nonvolatile memory such as read-only memory (ROM), programmable read-only memory (PROM), erasable programmable read-only memory (EPROM), electrically erasable programmable read-only memory (EEPROM), flash memory, phase-change random access memory (PRAM), magnetoresistive random access memory (MRAM), resistive random access memory (RRAM), or ferroelectric random access memory (FRAM), volatile memory such as dynamic random access memory (DRAM), static random access memory (SRAM), synchronous dynamic random access memory (SDRAM), or a memory device such as hard disk drive (HDD), solid-state drive (SSD), secure digital (SD), or Micro-SD. The processor 1322 may include at least one of a microprocessor, a central processing unit (CPU), a graphics processing unit (GPU), and an application processor (AP).

The processor 1322 may be configured to determine the operating range of the battery pack 120 based on the battery state variables by executing instructions stored in the memory 1321. The battery state variables may include, for example, a SOC, a SOHC, and a SOHR of the cells of the battery pack 120. The operating range of the battery pack 120 may include an SOC operating range, which may be defined by an upper SOC limit and a lower SOC limit.

The processor 1322 may be configured to calculate degradation rates of the battery state variables based on the energy degradation parameters by executing the instructions stored in the memory 1321. The energy degradation parameters (α1, α2) may be defined to indicate the ratio at which variations in SOHC and SOHR affect the energy degradation of the battery pack 120. Based on these parameters, the degradation rates (ΔSOHC, ΔSOHR) of the battery state variables may be calculated.

The processor 1322 may be configured to measure the usable battery energy (UBE) to be supplied by the battery pack 120 based on a standard test pattern by executing the instructions stored in the memory 1321. For example, the standard test pattern may include the WLTP pattern. While the vehicle 100 is driven according to the WLTP pattern, the UBE value of each cell in the battery pack 120 may be calculated, and based on these values, the pack UBE value and vehicle UBE value may be measured. The UBE value may refer to the energy to be supplied by the battery pack 120 until the vehicle 100 reaches the termination condition while driving according to the WLTP pattern after the battery pack 120 is fully charged.

The processor 1322 may be configured to estimate the SOCE of the battery pack 120 by comparing a measured UBE value with a reference UBE value by executing the instructions stored in the memory 1321. For example, the vehicle UBE value measured for the vehicle 100 may be compared with the reference UBE value of the vehicle 100, and the reduction rate of the UBE value may be the SOCE. The reference UBE value may be a certified value provided by the manufacturer of the vehicle 100.

According to the embodiment, the battery management apparatus 130 may further include a sensor 131 configured to collect battery data from the battery pack 120, and the processor 1322 may be configured to generate battery state variables based on the battery data. The battery data may include temperature data and voltage data, and the sensor 131 may periodically measure the temperature and voltage of each battery cell of the battery pack 120. Based on the temperature and voltage of each battery cell, battery state variables such as the SOC, the SOHC, and the SOHR may be generated.

According to an embodiment, the battery state variables may include the SOC, the SOHC, and the SOHR of the battery pack 120, and the operating range may include an SOC operating range defined by an upper SOC limit and a lower SOC limit. The upper SOC limit (SOCₛₜₐᵣₜ) and lower SOC limit (SOC_{end}) may indicate an actual operating range of each battery cell of the battery pack 120.

According to an embodiment, the energy degradation parameters may include a first degradation parameter related to the rate at which the decrease in SOHC contributes to energy degradation, and a second degradation parameter related to the rate at which the increase in SOHR contributes to energy degradation. The first degradation parameter (α1) and the second degradation parameter (α2) may be newly designed values for estimating the SOCE value using the battery management apparatus 130. The degradation rate values (ΔSOHC, ΔSOHR) may be determined by the first degradation parameter (α1) and the second degradation parameter (α2)

According to an embodiment, the degradation rate values of the battery state variables may include a first degradation rate value related to the degradation of the SOHC and a second degradation rate value related to the degradation of the SOHR. The first degradation rate value (ΔSOHC) of each battery cell in the battery pack 120 may indicate the rate at which the SOHC degrades according to the first degradation parameter (α1), and the second degradation rate value (ΔSOHR) of each battery cell may indicate the rate at which the SOHR degrades according to the second degradation parameter (α2)

According to an embodiment, the battery pack 120 may include multiple battery cells, and the processor 1322 may be configured to determine multiple of SOC operating ranges based on multiple SOCs corresponding to the multiple battery cells and to measure the UBE based on the multiple SOHCs, the multiple SOHRs, and the multiple SOC operating ranges corresponding to the multiple battery cells. For each of the multiple battery cells, the SOC value, the SOHC value, and the SOHR value may be calculated, and based on these values, the cell UBE value of each battery cell may be determined. Based on the cell UBE values of the multiple battery cells, the pack UBE value of the battery pack 120 may be determined.

According to an embodiment, the processor 1322 may be configured to calculate the maximum SOC value, the minimum SOC value, and the average SOC value based on the multiple SOCs, to select the representative SOHC and SOHR values from the multiple SOHCs and the multiple SOHRs, and to measure the UBE based on the maximum SOC value, the minimum SOC value, the average SOC value, representative SOHC value, and representative SOHR value. Instead of calculating n UBE values for all n battery cells, a single cell UBE value may be calculated using the representative values of the SOX values. The representative SOHC value may be, for example, the average, quartile, or median of the n SOHC values, and the representative SOHR value may be the average, quartile, or median of the n SOHR values.

According to an embodiment, the processor 1322 may be configured to calculate the cell UBE value of each of the multiple battery cells based on the multiple SOHCs), the multiple SOHRs, and the multiple SOC operating ranges, and to calculate the pack UBE value of the battery pack 120 based on the energy loss due to the internal resistance of the battery pack 120 and the cell UBE values of the multiple battery cells. Based on the n cell UBE values for the n battery cells, the pack UBE value reflecting the energy loss caused by the inherent resistance of the battery pack 120 may be calculated.

According to an embodiment, the processor 1322 may be configured to calculate the vehicle UBE value based on the energy efficiency of the power system of the vehicle 100, which uses the battery pack 120 as a power source, and the pack UBE value, and to estimate the SOCE by comparing the vehicle UBE value with a reference UBE value. As the powertrain of the vehicle 100 and the EV platform are designed to be highly efficient, the energy efficiency of the power system may approach 1. The reference UBE value may represent the initial performance of the vehicle 100, and the SOCE value may indicate the extent to which the initial performance has degraded.

According to an embodiment, the processor 1322 may be configured to calculate the cell UBE value of each of the multiple battery cells using at least one of an energy map and an equivalent circuit model. The cell UBE value may be calculated based on the SOC operating range (from the lower SOC limit to the upper SOC limit) of each battery cell, the first degradation rate value (ΔSOHC), and the second degradation rate value (ΔSOHR). For this purpose, an energy map (Emap) method and/or an equivalent circuit model (ECM) method may be utilized. For example, a weighted average of both methods may be used, and the weighting values may be determined based on factors such as the type of vehicle 100, the type of battery pack 120, and seasonal/weather information.

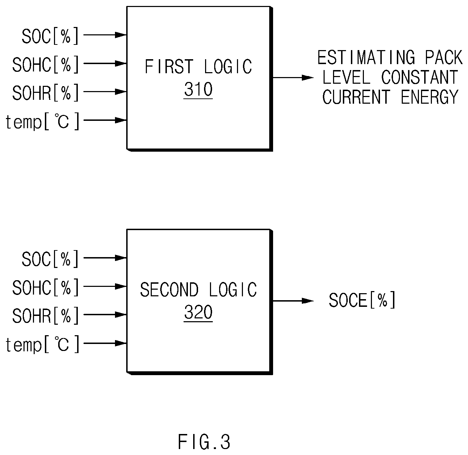

FIG. 3 illustrates a first logic and a second logic for estimating energy durability according to an embodiment.

Referring to FIG. 3, the first logic 310 for estimating energy durability may estimate the CC energy at the pack level based on the SOC, SOHC, SOHR, and temperature, while the second logic 320 for estimating energy durability may estimate the SOCE value based on the same input values. The first logic 310 may correspond to a conventional logic for estimating energy durability, and the second logic 320 may correspond to a newly designed logic for estimating energy durability.

The first logic 310 may use the CC energy at the pack level as an indicator for estimating energy durability. In contrast, the second logic 320 may use the SOCE value as the indicator. The SOCE value may be an indicator newly introduced for evaluating the energy durability of vehicle batteries in accordance with the establishment of the GTR 22 International Standard. According to an embodiment, instructions for implementing the second logic 320 may be stored in the memory 1321, and the processor 1322 may execute the instructions for implementing the second logic 320 to estimate the energy durability.

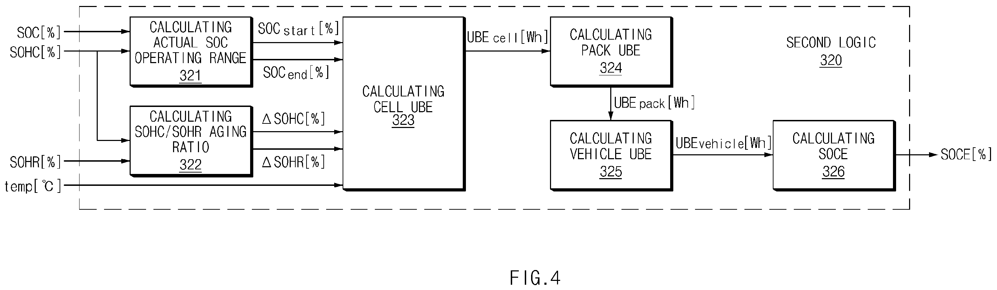

FIG. 4 illustrates a process in which the second logic operates according to an embodiment.

Referring to FIG. 4, the second logic 320 may include a first step 321 for calculating an actual SOC operating range, a second step 322 for calculating an SOHC/SOHR aging ratio, a third step 323 for calculating a cell UBE, a fourth step 324 for calculating a pack UBE, a fifth step 325 for calculating a vehicle UBE, and a sixth step 326 for calculating an SOCE.

The first step 321 and the second step 322 may be performed in the third step 323 to calculate the cell UBE for each battery cell of the battery pack 120. The calculation of the UBE may include the third step 323 at the cell level, the fourth step 324 at the pack level, and the fifth step 325 at the vehicle level. Finally, as the SOCE is calculated in the sixth step 326, the energy durability value for xEV that complies with the GTR 22 International Standard may be estimated.

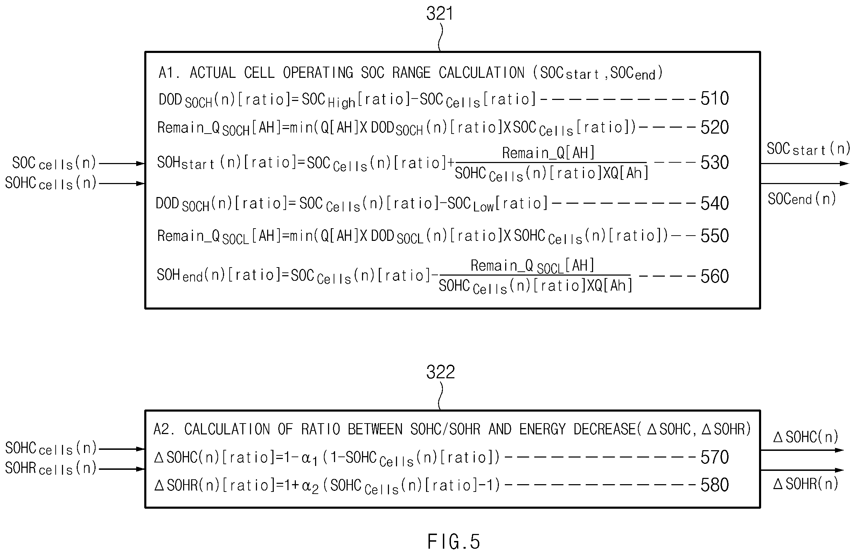

FIGS. 5 to 7 each illustrate each step of the second logic for estimating an SOCE according to an embodiment.

FIG. 5 illustrates the calculation methods of the first step 321 for calculating an actual SOC operating range and the second step 322 for calculating an SOHC/SOHR aging ratio according to an embodiment.

In the first step 321, the cell SOC values (SOC_{cells}) and cell SOHC values (SOHC_{cells}) of the n battery cells in the battery pack 120 may be input. The cell SOC values (SOC_{cells}) and cell SOHC values (SOHC_{cells}) may be calculated by the battery management apparatus 130 based on battery data, including, for example, voltage, current, and temperature.

In the first step 321, the upper SOC limit (SOCₛₜₐᵣₜ) may be calculated using first to third equations 510 to 530 based on the high values of SOC and the depth of discharge (DOD), and the lower SOC limit (SOC_{end}) may be calculated using fourth to sixth equations 540 to 560 based on the low values of the SOC and the DOD. In the first step 321, Q may refer to the reference current capacity of a fresh cell.

In the second step 322, the cell SOHC values (SOHC_{cells}) and cell SOHR values (SOHR_{cells}) of the n battery cells may be input. The cell SOHR values (SOHR_{cells}) may be calculated by the battery management apparatus 130 based on battery data, including, for example, voltage, current, and temperature.

In the second step 322, the first degradation rate value (ΔSOHC) may be calculated using a seventh equation 570 based on the first degradation parameter (α1), which relates to the rate at which a decrease in SOHC contributes to the energy degradation of the battery pack 120, and the second degradation rate value (ΔSOHR) may be calculated using an eighth equation 580 based on the second degradation parameter (α2), which relates to the rate at which an increase in SOHR contributes to the energy degradation of the battery pack 120. The first degradation parameter (α1) and the second degradation parameter (α2) may not be present in the first logic 310 and may be newly designed parameters in the second logic 320.

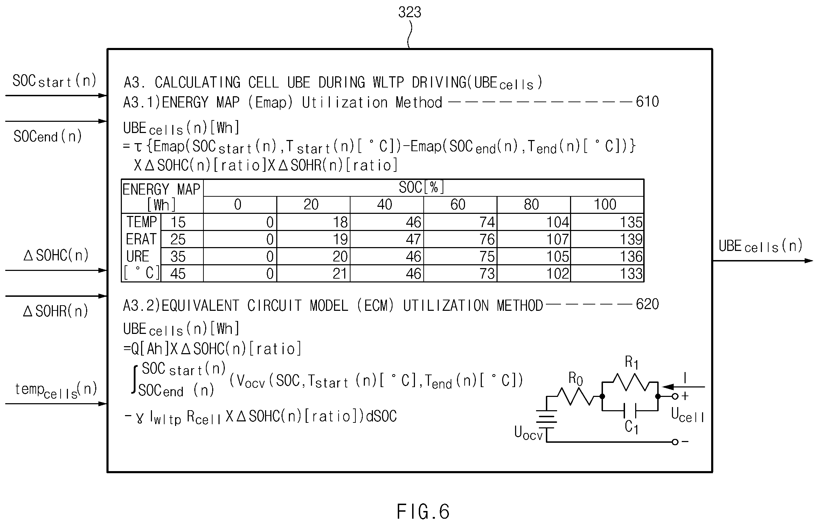

FIG. 6 illustrates a detailed calculation method of the third step 323 for calculating a cell UBE according to an embodiment.

In the third step 323, which is for calculating a cell UBE value, the upper SOC limit (SOCₛₜₐᵣₜ) and lower SOC limit (SOC_{end}) calculated in the first step 321, the first degradation rate value (ΔSOHC) and the second degradation rate value (ΔSOHR) calculated in the second step 322, and the cell temperature values (temp_{cells}) measured by the sensor 131, may be input. The cell UBE value may be calculated using an energy map (Emap) method 610 and/or an ECM method 620.

The Emap method 610 may be performed based on an Emap that defines the mapping relationship between the SOC values and the temperature values. The ECM method 620 may be used to calculate the cell UBE value by obtaining an equivalent circuit of each battery cell and integrating an open circuit voltage (OCV) over an SOC operating range. In the equation for the ECM method 620 illustrated in FIG. 6, γ may represent the battery energy efficiency when driving according to a WLTP pattern, I_{wltp} may represent the root mean squared error (RMSE) value of the overall section current when driving according to the WLTP pattern, and R_{cell} may represent the internal resistance of each battery cell.

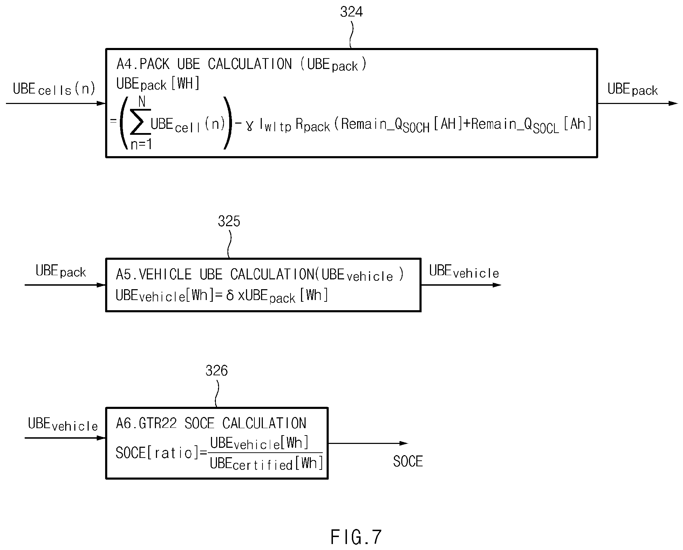

FIG. 7 illustrates the detailed calculation methods of the fourth step 324 for calculating a pack UBE, the fifth step 325 for calculating a vehicle UBE, and the sixth step 326 for calculating an SOCE according to an embodiment.

In the fourth step 324 of FIG. 7, the cell UBE values (UBE_{cells}) calculated in the third step 323 of FIG. 6 may be input to calculate the pack UBE value (UBE_{pack}). The pack UBE value (UBE_{pack}) may be calculated by subtracting a term that models the loss due to the internal resistance of the battery pack 120 from the total sum of the cell UBE values (UBE_{cells}). In the equation for the fourth step 324 of FIG. 7, γ may represent the battery energy efficiency when driving according to the WLTP pattern, I_{wltp} may represent the RMSE value of the overall section current when driving according to the WLTP pattern, and R_{pack} may represent the internal resistance of the battery pack 120. The internal resistance of the battery pack 120 may include resistance from pack components such as bus bars.

In the fifth step 325 of FIG. 7, the pack UBE value (UBE_{pack}) calculated in the fourth step 324 may be input to calculate the vehicle UBE value (UBE_{vehicle}). The vehicle UBE value (UBE_{vehicle}) may be calculated by considering the energy efficiency of the power system of the vehicle 100. The symbol δ may represent the energy efficiency of the powertrain of the vehicle 100 when driving according to the WLTC pattern.

In the sixth step 326 of FIG. 7, the vehicle UBE value (UBE_{vehicle}) calculated in the fifth step 325 may be input to calculate the SOCE value. The SOCE value may a value obtained by dividing the calculated result of the vehicle UBE value (UBE_{vehicle}) by the certified UBE value (UBE_{certified}) of the vehicle 100. The certified UBE value (UBE_{certified}) may be a reference value provided by the manufacturer of the vehicle 100.

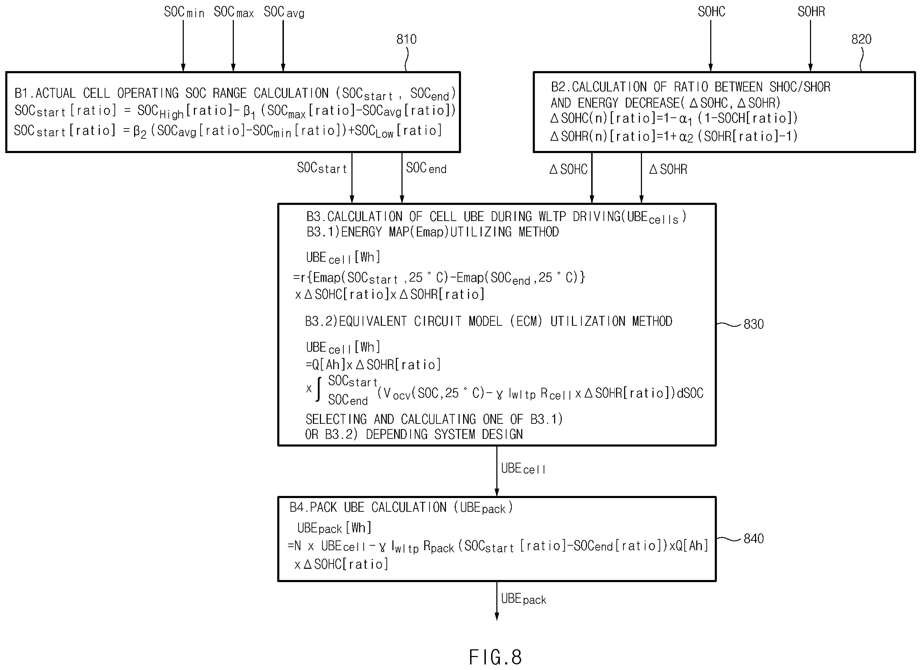

FIG. 8 illustrates a process of estimating an SOCE using representative values according to an embodiment.

Referring to FIG. 8, the process in which the battery management apparatus 130 estimates the SOCE using representative values without calculating the SOX of all cells may include first to fourth steps 810 to 840. The first to fourth steps 810 to 840 may either replace or be performed in parallel with the first to fourth steps 321 to 324 of FIGS. 4 to 7.

In the first step 810, instead of inputting n SOC values (SOC_{cells}) for n battery cells, the minimum SOC value (SOCₘᵢₙ), maximum SOC value (SOCₘₐₓ), and average SOC value (SOC_{avg}) may be input. Alternatively, other representative values such as quartile or median may be used. The minimum SOC value (SOCₘᵢₙ), maximum SOC value (SOCₘₐₓ), and SOC average value (SOC_{avg}) may be derived based on the n SOC values (SOC_{cells}). Here, the parameters (β1, β2) may represent the rate at which the SOC imbalance of n battery cells of the battery pack 120 increases or decreases the average SOC at full charge and full discharge. In the first step 810, the upper SOC limit (SOCₛₜₐᵣₜ) and lower SOC limit (SOC_{end}) may be calculated.

In the second step 820, instead of using the n SOHC values (SOHC_{cells}) and n SOHR values (SOHR_{cells}) for the n battery cells, representative SOHC and SOHR values may be used. The representative SOHC and SOHR values may be, for example, an average, median, or quartile. In the second step 820, the first degradation rate value (ΔSOHC) and the second degradation rate value (ΔSOHR) may be calculated.

In the third step 830, instead of using n temperature values (temp_{cells}) for the n battery cells, a representative temperature value may be used. For example, the representative temperature value may be 25°C, but it may be changed to another appropriate value. The representative temperature value of 25°C may be used in both the Emap method and the ECM method. In the third step 830, a cell UBE value (UBE_{cell}) may be calculated.

In the fourth step 840, instead of adding all n cell UBE values (UBE_{cells}) for the n battery cells, a method of simply multiplying the cell UBE value (UBE_{cell}) calculated in the third step 830 by the number of cells (n) may be used. In the fourth step 840, a pack UBE value (UBE_{pack}) may be calculated.

The subsequent steps proceed similarly to the fifth and sixth steps 325 and 326 of FIG. 7 to calculate the vehicle UBE value (UBE_{vehicle}) and, based on this, calculate the SOCE value for GTR 22. In this way, the calculation efficiency may be improved through the representative value calculation method illustrated in FIG. 8.

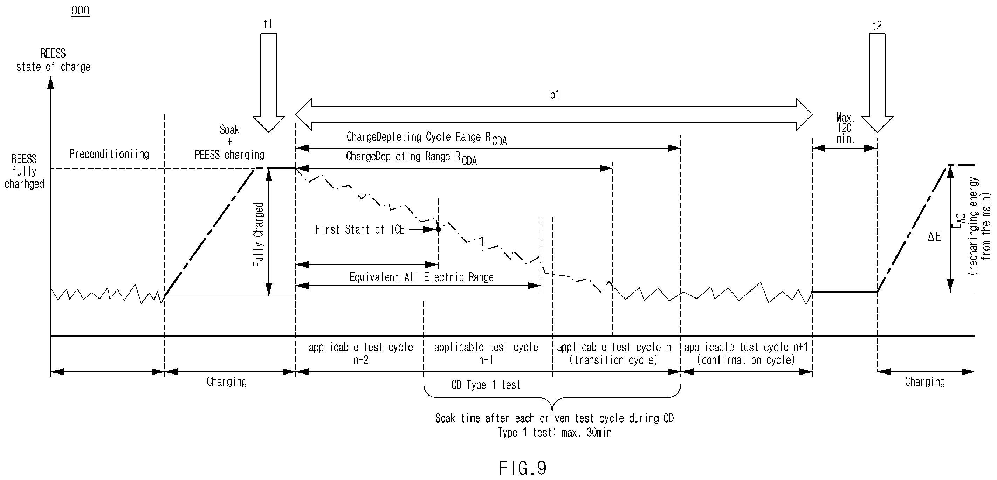

FIG. 9 illustrates the WLTP performed to estimate the state of certified energy (SOCE) according to an embodiment.

Referring to FIG. 9, a graph 900 representing a WLTP driving test conducted to estimate the SOCE may be shown.

According to an embodiment, the graph 900 may represent a test for a PHEV. In the graph 900, the horizontal axis may represent time, and the vertical axis may represent the SOC of a rechargeable energy storage system (REESS).

In the graph 900, charging may be performed through a preconditioning process, and the charging may be completed at a first time point t1, which is indicated by a vertical arrow. At the first time point t1, the battery management apparatus 130 may estimate the SOCE, the value of the SOCE may be recorded as SOCE_{read}.

After the first time point t1 has elapsed, the vehicle 100 may travel according to the WLTP pattern during a first section p1. As the traveling progresses, the battery pack 120 may discharge, causing the SOC to decrease. The first section p1 may include an all-electric range, which refers to a section up to the first start-up point of an internal combustion engine (ICE). The first section p1 may also include an equivalent all-electric range.

The first section p1 may include a full discharge point and an end point of a full discharge cycle, and a charge depleting range (RCDA) and a charge depleting cycle (RCDC) may be determined based on the full discharge point and the end point of a full discharge cycle. Based on the energy supplied by the battery pack 120 in the first section p1, the measured UBE value (UBE_{measured}) may be calculated. A SOCE value (SOCE_{measured}) may be calculated according to the ratio of a measured UBE value (UBE_{measured}) to a certified UBE value (UBE_{certified}). The accuracy of SOCE estimation logic may be calculated by the difference/ratio between the measured SOCE value (SOCE_{measured}) and the reference SOCE value (SOCE_{read}), and if this difference exceeds the reference value, it may be subject to a software (SW) recall.

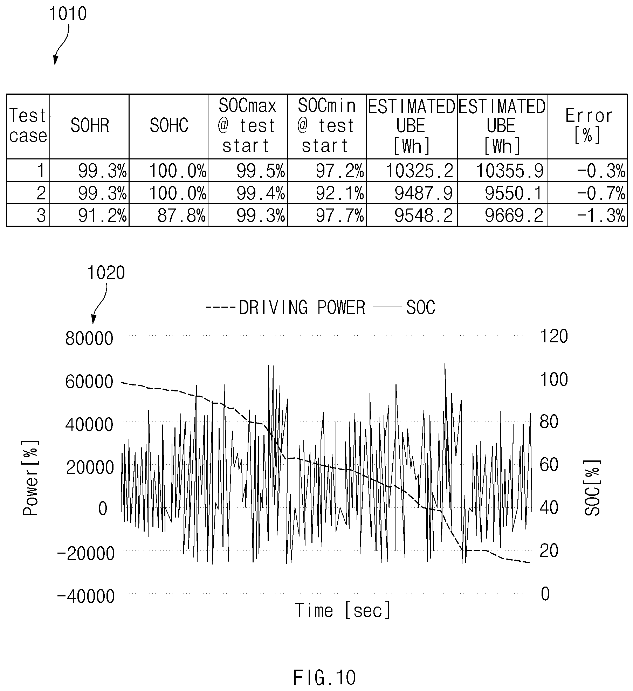

FIG. 10 illustrates test cases for estimating the SOCE according to an embodiment.

Referring to FIG. 10, a table 1010 and a graph 1020 illustrating test cases for estimating the SOCE may be illustrated.

The table 1010 may present three test cases. Case 1 may correspond to a new battery pack with a low SOC imbalance (SOCₘₐₓ - SOCₘᵢₙ = 2.3%). Case 2 may correspond to a new battery pack with a high SOC imbalance (SOCₘₐₓ - SOCₘᵢₙ = 7.3%).

Case 3 may correspond to an aged battery pack with a low SOHC value (SOHC = 91.2%). The graph 1020 may represent the measured vehicle driving power and battery pack SOC for Case 3. The driving power measured as the vehicle drives according to a WLTP pattern may be shown, and the test results may show that the battery pack SOC converged to the termination condition.

The table 1010 may present the results of the test cases. The UBE error for Case 1 may be -0.3%, and the UBE error for Case 2 may be -0.7%. This indicates that as the SOC imbalance decreases, the UBE error also decreases. Case 3, which corresponds to a low SOHC value, may show a relatively higher UBE error (-1.3%).

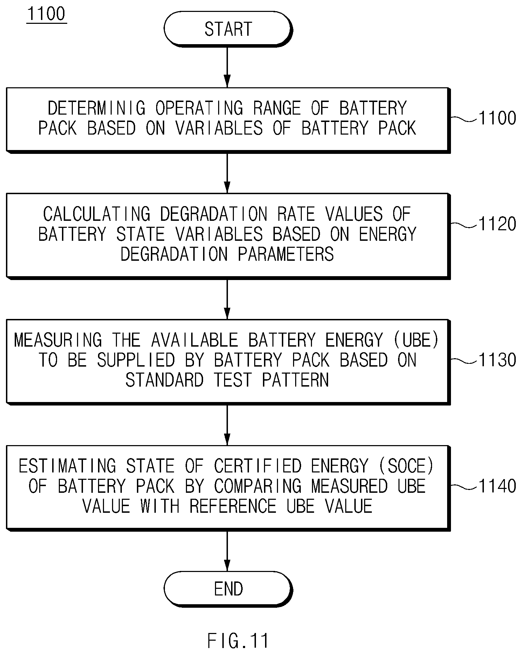

FIG. 11 illustrates steps constituting a battery management method according to an embodiment.

Referring to FIG. 11, the battery management method 1100 may include steps 1110 to 1140. However, without being limited thereto, some steps may be omitted or other general-purpose steps may be added, and the steps of the battery management method 1100 may be executed in a different order from the illustrated order.

The battery management method 1100 may include steps processed in time series by the battery management apparatus 130. Therefore, even when a description is omitted below, the descriptions above regarding the battery management apparatus 130 may be equally applicable to the battery management method 1100.

The steps 1110 to 1140 of the battery management method 1100 may be performed by the sensor 131 and the controller 132 of the battery management apparatus 130.

In step 1100, the battery management apparatus 130 may perform a step of determining an operating range of a battery pack based on battery state variables.

In step 1120, the battery management apparatus 130 may perform a step of calculating degradation rate values of the battery state variables based on energy degradation parameters.

In step 1130, the battery management apparatus 130 may perform a step of measuring the UBE to be supplied by the battery pack based on a standard test pattern.

In step 1140, the battery management apparatus 130 may perform a step of estimating the SOCE of the battery pack by comparing a measured UBE value with a reference UBE value.

According to an embodiment, the battery management method 1100 may be implemented in the form of a computer program stored in a computer-readable storage medium. That is, the computer program may include instructions for implementing the battery management method 1100, and the instructions of the program may be stored in a computer-readable storage medium. The computer program may include a mobile application.

According to an embodiment, the computer-readable storage medium may include a magnetic medium such as a hard disk, a floppy disk, or a magnetic tape, an optical medium such as a CD-ROM or a DVD, a magneto-optical medium such as a floptical disk, and a hardware device configured specifically to store and execute computer program instructions, such as ROM, RAM, or flash memory. Computer program instructions may include machine language code created by a compiler and high-level language code capable of being executed by a computer using, for example, an interpreter.

The terms such as "include," "comprise," or "have," as used above, mean that the corresponding component may be inherent, unless specifically stated to the contrary. Therefore, these terms should not be interpreted as excluding other components, but rather as being capable of further including other components. All terms, including technical or scientific terms, have the same meaning as generally understood by a person ordinarily skilled in the art to which the embodiments disclosed herein pertain, unless otherwise defined. Commonly used terms, as defined in dictionaries, should be interpreted as consistent with the context of the relevant technology, and should not be interpreted in an idealized or overly formal sense unless explicitly defined herein.

In the above description, although the present disclosure has been described by limited embodiments and drawings, the above description is merely an example of the technical idea of the present disclosure, and those skilled in the art will appreciate that various modifications and variations may be made without departing from the essential characteristics of the present disclosure. Therefore, the embodiments disclosed in the present disclosure are not intended to limit the technical idea of the present disclosure, but rather to explain it, and the scope of the technical idea of the present disclosure is not limited by these embodiments. The scope of protection of the present disclosure should be interpreted by the claims below, and all technical ideas within the scope equivalent thereto should be interpreted as being included in the scope of the rights of the present disclosure.

## Claims

1. A battery management apparatus comprising:
a memory; and
a processor operatively connected to the memory,
wherein the processor is configured to:
determine an operating range of a battery pack based on battery state variables;
calculate degradation rate values of the battery state variables based on energy degradation parameters;
measure a usable battery energy (UBE) to be supplied by the battery pack based on a standard test pattern; and
estimate a state of certified energy (SOCE) of the battery pack by comparing a measured UBE value with a reference UBE value.

2. The battery management apparatus of claim 1, further comprising:
a sensor configured to collect battery data from the battery pack,
wherein the processor is configured to generate the battery state variables based on the battery data.

3. The battery management apparatus of claim 1, wherein the battery state variables include a state of charge (SOC), a state of health capacity (SOHC), and a state of health resistance (SOHR) of the battery pack, and
wherein the operating range includes an SOC operating range defined by an upper SOC limit and a lower SOC limit.

4. The battery management apparatus of claim 3, wherein the energy degradation parameters include a first degradation parameter related to a rate at which a decrease in the SOHC contributes to energy degradation, and a second degradation parameter related to a rate at which an increase in the SOHR contributes to energy degradation.

5. The battery management apparatus of claim 4, wherein the degradation rate values of the battery state variables include a first degradation rate value related to the degradation of the SOHC and a second degradation rate value related to the degradation of the SOHR.

6. The battery management apparatus of claim 3, wherein the battery pack includes multiple battery cells, and
wherein the processor is configured to:
determine multiple SOC operating ranges based on multiple SOCs corresponding to the multiple battery cells; and
measure the UBE based on multiple SOHCs, multiple SOHRs, and the multiple SOC operating ranges corresponding to the multiple battery cells.

7. The battery management apparatus of claim 6, wherein the processor is configured to:
calculate a maximum SOC value, a minimum SOC value, and an average SOC value based on the multiple SOCs;
select a representative SOHC value and a representative SOHR value from the multiple SOHCs and SOHRs; and
measure the UBE based on the maximum SOC value, the minimum SOC value, the average SOC value, the representative SOHC value, and the representative SOHR value.

8. The battery management apparatus of claim 6, wherein the processor is configured to:
calculate a cell UBE value for each of the multiple battery cells based on the multiple SOHCs, the multiple SOHRs, and the multiple SOC operating ranges; and
calculate a pack UBE value of the battery pack based on an energy loss caused by an internal resistance of the battery pack and the cell UBE values of the multiple battery cells.

9. The battery management apparatus of claim 8, wherein the processor is configured to:
calculate a vehicle UBE value based on an energy efficiency of a power system of a vehicle that uses the battery pack as a power source and the pack UBE value; and
estimate the SOCE by comparing the vehicle UBE value with the reference UBE value.

10. The battery management apparatus of claim 8, wherein the processor is configured to calculate the cell UBE value for each of the multiple battery cells using at least one of an energy map (Emap) and an equivalent circuit model (ECM).

11. A battery management method comprising:
determining an operating range of a battery pack based on battery state variables;
calculating degradation rate values of the battery state variables based on energy degradation parameters;
measuring a usable battery energy (UBE) to be supplied by the battery pack based on a standard test pattern; and
estimating a state of certified energy (SOCE) of the battery pack by comparing a measured UBE value with a reference UBE value.

12. The battery management method of claim 11, wherein the battery state variables include a state of charge (SOC), a state of health capacity (SOHC), and a state of health resistance (SOHR) of the battery pack, and
wherein the operating range includes an SOC operating range defined by an upper SOC limit and a lower SOC limit.

13. The battery management method of claim 12, wherein the battery pack includes multiple battery cells, and
wherein the measuring the UBE includes:
determining multiple SOC operating ranges based on multiple SOCs corresponding to the multiple battery cells; and
measuring the UBE based on multiple SOHCs, multiple SOHRs, and the multiple SOC operating ranges corresponding to the multiple battery cells.

14. The battery management method of claim 13, wherein the measuring the UBE includes:
calculating a cell UBE value for each of the multiple battery cells based on the multiple SOHCs, the multiple SOHRs, and the multiple SOC operating ranges; and
calculating a pack UBE value of the battery pack based on an energy loss caused by an internal resistance of the battery pack and the cell UBE values of the multiple battery cells.

15. The battery management method of claim 14, wherein the estimating the SOCE includes:
calculating a vehicle UBE value based on an energy efficiency of a power system of a vehicle using the battery pack as a power source and the pack UBE value; and
estimating the SOCE by comparing the vehicle UBE value with the reference UBE value.

16. A vehicle comprising:
a battery pack; and
a battery management apparatus,
wherein the management apparatus is configured to:
determine an operating range of the battery pack based on battery state variables;
calculate degradation rate values of the battery state variables based on energy degradation parameters;
measure a usable battery energy (UBE) to be supplied by the battery pack based on a standard test pattern; and
estimate a state of certified energy (SOCE) of the battery pack by comparing a measured UBE value with a reference UBE value.

17. The vehicle of claim 16, wherein the battery state variables include a state of charge (SOC), a state of health capacity (SOHC), and a state of health resistance (SOHR) of the battery pack, and
wherein the operating range includes an SOC operating range defined by an upper SOC limit and a lower SOC limit.

18. The vehicle of claim 17, wherein the battery pack includes multiple battery cells, and
wherein the battery management apparatus is configured to:
determine multiple SOC operating ranges based on multiple SOCs corresponding to the multiple battery cells; and
measure the UBE based on multiple SOHCs, multiple SOHRs, and the multiple SOC operating ranges corresponding to the multiple battery cells.

19. The vehicle of claim 18, wherein the battery management apparatus is configured to:
calculate a cell UBE value for each of the multiple battery cells based on the multiple SOHCs, the multiple SOHRs, and the multiple SOC operating ranges; and
calculate a pack UBE value of the battery pack based on an energy loss caused by an internal resistance of the battery pack and the cell UBE values of the multiple battery cells.

20. The vehicle of claim 19, wherein the battery apparatus is configured to:
calculate a vehicle UBE value based on an energy efficiency of a power system of a vehicle that uses the battery pack as a power source and the pack UBE value; and
estimate the SOCE by comparing the vehicle UBE value with the reference UBE value.
